# EUROPEAN PATENT APPLICATION

(11) **EP 1 945 015 A2**
(43) Date of publication of application: **16.07.2008**
(21) Application number: 07008868.7
(22) Date of filing: 02.05.2007
(51) Int. Cl.: H05K 7/20, H05K 1/02

(54) **Combination assembly of a LED and a liquid-vapor thermally dissipating device**

(30) Priority: 12.01.2007 CN 200710003719
(71) Applicant: Tai-Sol Electronics Co., Ltd., Neihu District Taipei City 114 (TW)
(72) Inventor: Lai, Yaw-Huey, Jhonghe City Taipei County 235 (TW)
(74) Representative: Becker Kurig Straus

(57) **Abstract**

A combination assembly of LED and liquid-vapor thermally dissipating device (10) includes a liquid-vapor thermally dissipating device (11), a circuit board (19) and at least one LED unit (21). The liquid-vapor thermally dissipating device (11) includes a metal shell (12) with liquid and capillarity structures therein. The circuit board (19) is provided on the liquid-vapor thermally dissipating device (11). The LED unit (21) includes a heat transmission base (22) provided on the metal shell (12) of the liquid-vapor thermally dissipating device (11), a LED chip (23) provided on the heat transmission base (22), a package device (24) encapsulating the LED chip (23) and two transmitting plates (231) having ends electrically connected to the LED chip (23) and ends exposed out of the package device (24) and electrically connected to the circuit board (19). The heat of the LED unit (21) may be transmitted to the liquid-vapor thermally dissipating device (11) directly for heat transmission. The present invention provides a greater heat transmission efficiency.

## Description

### BACKGROUND OF THE INVENTION

### 1. Field of the Invention

The present invention relates generally to a light emitting diode (LED), and more particularly to a combination assembly of LED and liquid-vapor thermally dissipating device, which has a greater performance in heat transmission.

### 2. Description of the Related Art

In present days, the high luminance LED produces high temperature, and there is no fine solution to fix it yet.

U.S. Patent no. 5,173,839 provides a heat transmission technique of a LED display. It provides a stack of a belt, an aluminum block, a belt and a heat sink under a LED chip to transmit the heat out. However, this technique provides three intermediates between the LED chip and the heat sink, which is the one performing heat transmission, that make the heat transmission rate is poor because the intermediates cause a greater heat resistance.

Taiwan Patent no. M295889 provides another heat transmission technique of LED. It provides a LED on a heat pipe. The LED includes a LED plastic insulating circuit board, a LED chip base, a LED heat chip and a LED lens. However, this technique provides the heat pipe, which has a high efficiency of heat transmission, to be the main for heat transmission, but there are also intermediates, the LED chip base and the LED plastic insulating circuit board, therebetween. These intermediates also cause the problem of high heat resistance and low heat transmission rate.

### SUMMARY OF THE INVENTION

The primary objective of the present invention is to provide a combination assembly of LED and liquid-vapor thermally dissipating device, which has a greater heat transmission performance for the LED.

According to the objective of the present invention, a combination assembly of LED and liquid-vapor thermally dissipating device includes a liquid-vapor thermally dissipating device, a circuit board and at least one LED unit. The liquid-vapor thermally dissipating device includes a metal shell with liquid and capillarity structures therein. The circuit board is provided on the liquid-vapor thermally dissipating device. The LED unit includes a heat transmission base provided on the metal shell of the liquid-vapor thermally dissipating device, a LED chip provided on the heat transmission base, a package device encapsulating the LED chip and two transmitting plates having ends electrically connected to the LED chip and ends exposed out of the package device and electrically connected to the circuit board.

The heat of the LED unit may be transmitted to the heat sink directly for heat transmission. The present invention provides a greater heat transmission efficiency.

### BRIEF DESCRIPTION OF THE DRAWINGS

FIG 1 is a perspective view of a first preferred embodiment of the present invention;
FIG 2 is a top view of the first preferred embodiment of the present invention;
FIG 3 is a sectional view along the 3-3 line of FIG 2;
FIG 4 is a sectional view of the first preferred embodiment of the present invention, showing another package device;
FIG 5 is a perspective view of a second preferred embodiment of the present invention;
FIG 6 is a perspective view of a third preferred embodiment of the present invention;
FIG 7 is a top view of the third preferred embodiment of the present invention;
FIG 8 is a sectional view along the 8-8 line of FIG. 7; and
FIG. 9 is a perspective view of a fourth preferred embodiment of the present invention.

### DETAILED DESCRIPTION OF THE INVENTION

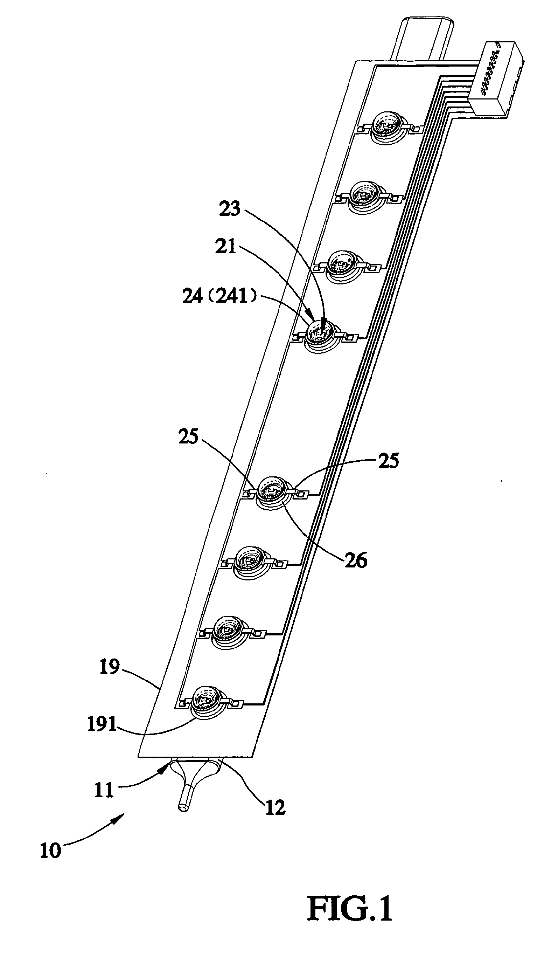

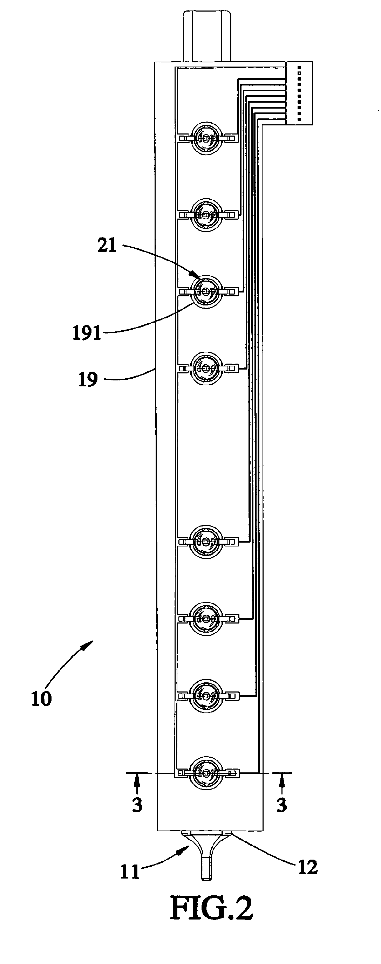

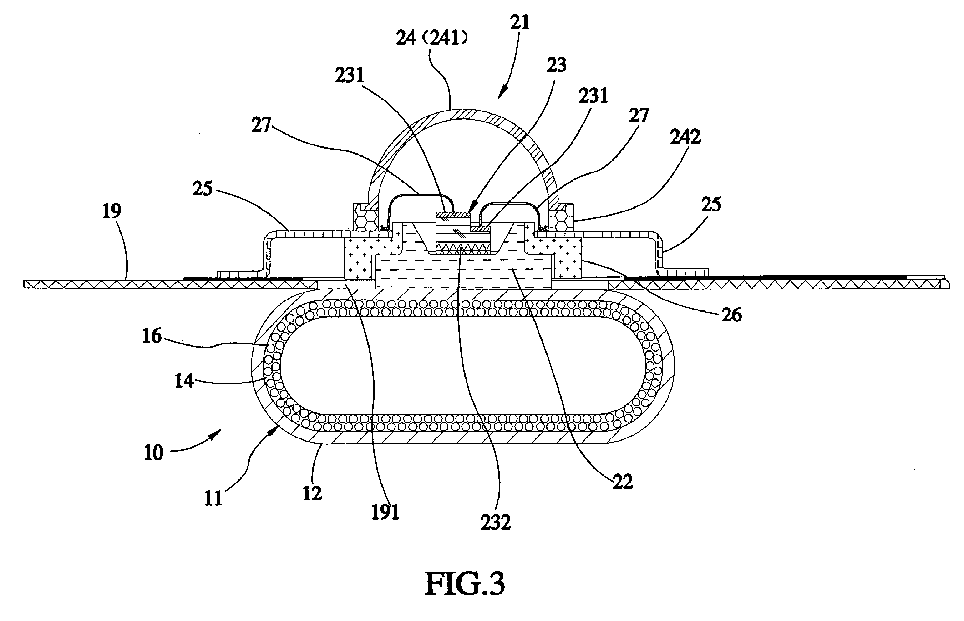

As shown in FIG 1 to FIG 3, a combination assembly of LED and liquid-vapor thermally dissipating device 10 of the first preferred embodiment of the present invention mainly includes a liquid-vapor thermally dissipating device 11, a circuit board 19 and a plurality of LED units 21.

The liquid-vapor thermally dissipating device 11 includes a metal shell 12, which is a copper heat pipe in the present embodiment, liquid 14 in the metal shell 12 and a capillarity structure 16. The liquid-vapor thermally dissipating device 11 is a heat pipe in the present embodiment.

The circuit board 19, which is mounted on the liquid-vapor thermally dissipating device 11, has a plurality of bores 191 arranged in series.

The LED units 21, which are received in the bores 191 respectively, includes a heat transmission base 22, a LED chip 23, a package device 24, two transmitting plates 25, an insulating frame 26 and two wires 27. The LED chip 23 includes two electrode plates 231 at a top thereof and an insulating player 232 at a bottom thereof. The LED chip 23 has the insulating player 232 mounted on the heat transmission base 22. The heat transmission base 22, which has a high heat transmission efficiency, is mounted on the metal shell 12. The insulating frame 26 is an annular member surrounding the heat transmission base 22. The transmitting plates 25 have ends connected to the insulating frame 26. The wires 27 connect the electrodes plates 231 of the LED chip 23 and the transmitting plates 25 that the transmitting plates 25 are electrically connected to the electrode plates 231 of the LED chip 23. The package device 24 includes a lid 241 and a ring 242 in the present embodiment. The lid 241 is - connected to the ring 242 and the ring 242 is connected to the insulating frame 26. The LED chip 23 and the wires are between the package device 24 and the insulating frame 26, and the package device 24 encapsulates parts of the insulating frame 26 and the transmitting plates 25. The transmitting plates 25 have end exposed out of the package device 24 and electrically connected to the circuit board 19.

In operation of the first embodiment, an electronic driving device (not shown) is connected to the circuit board 19 to provide electricity to the LED chips 23 of the LED units 21 through the transmitting plates 25 to light the LED chips 23. The heat generated by the lighting LED chips 23 is transmitted to the metal shell 12 through the heat transmission base 22 to transmit the heat out by the liquid-vapor thermally dissipating device 11. Because of the high heat transmission efficiency of the liquid-vapor thermally dissipating device 11 and the heat transmission base 22, the heat of the lighting LED chips 23 is transmitted out quickly that provides the LED chip having a great heat transmission performance.

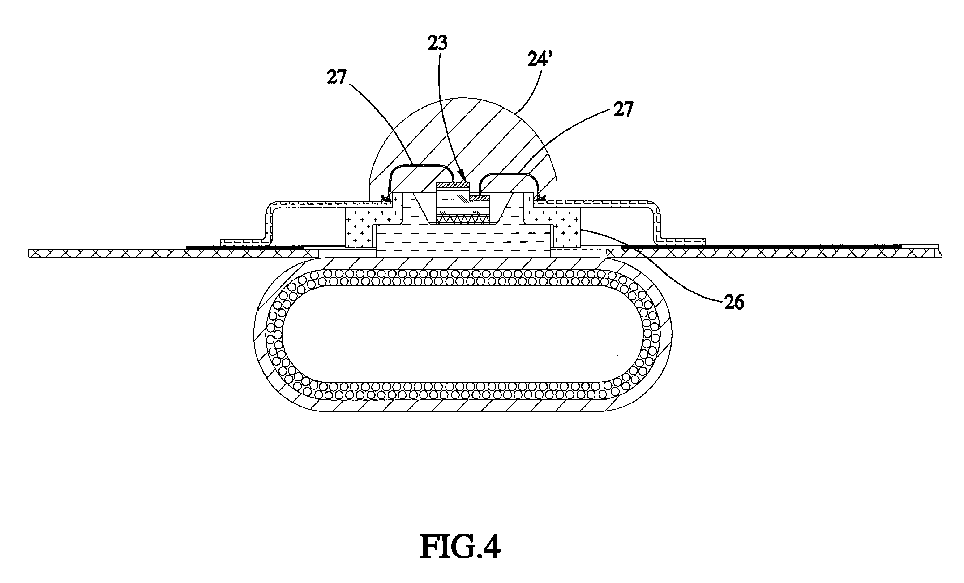

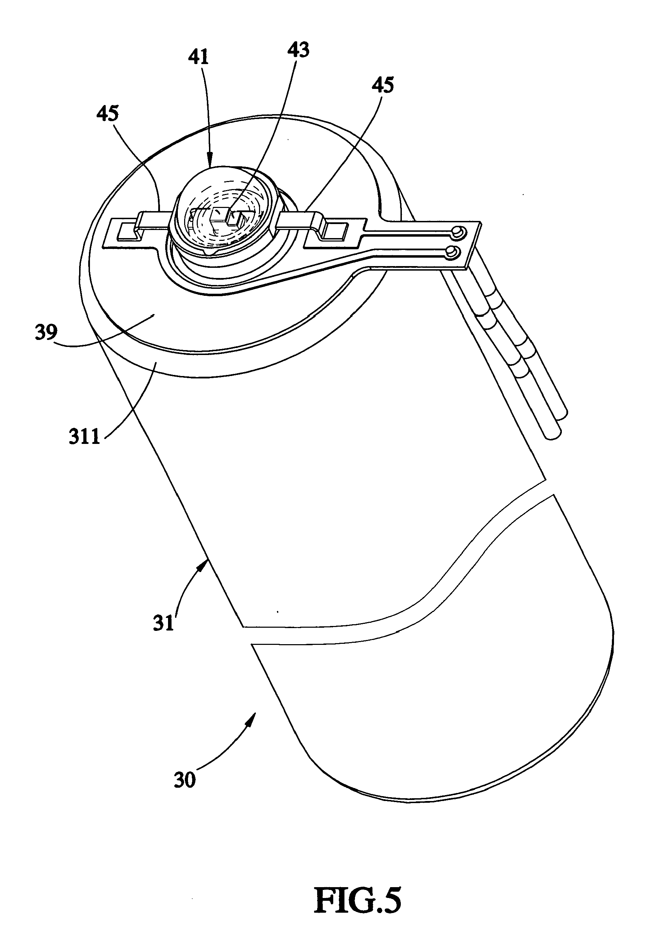

As shown in FIG. 4, an encapsulant 24', which is transparent or semi-transparent doped with fluorescence powder, encapsulating a top of the insulating frame 26, the wires 27 and the LED chip 23. It has the same function as the lid above. As shown in FIG. 5, a combination assembly of LED and liquid-vapor thermally dissipating device 30 of the second preferred embodiment of the present invention, which is similar to the assembly 10 of the first embodiment, except that:
A liquid-vapor thermally dissipating device 31 has an end face 311, on which a LED unit 41 is provided to fit the circuit board 39.
Electricity supplied to the transmitting plates 45 of the LED units 41 to light LED chips 43, and the liquid-vapor thermally dissipating device 31 transfers the heat of the lighting LED chips 43 of the LED units 41 out.

The operation mode and functions of the second embodiment are as same as the first embodiment, and we will not describe it again.

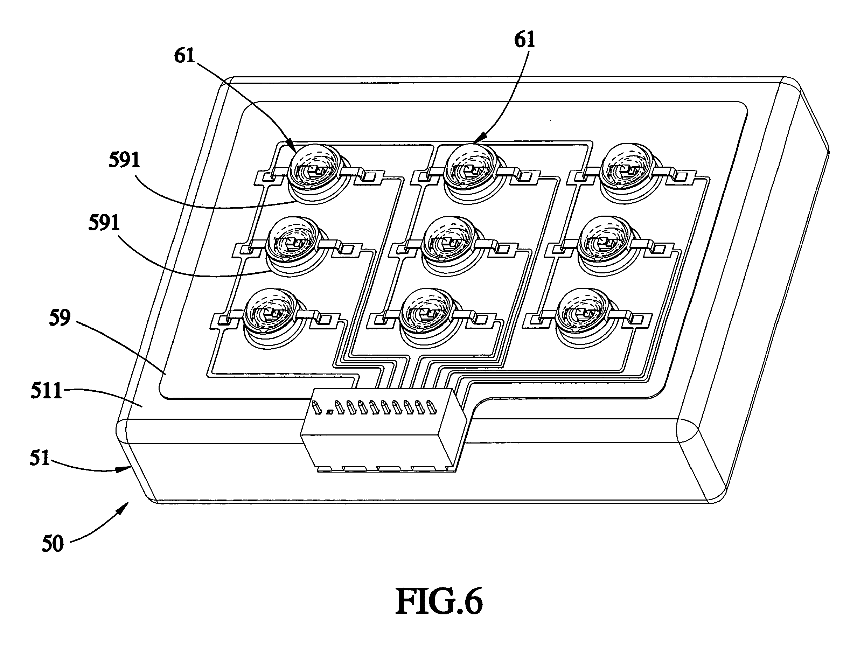

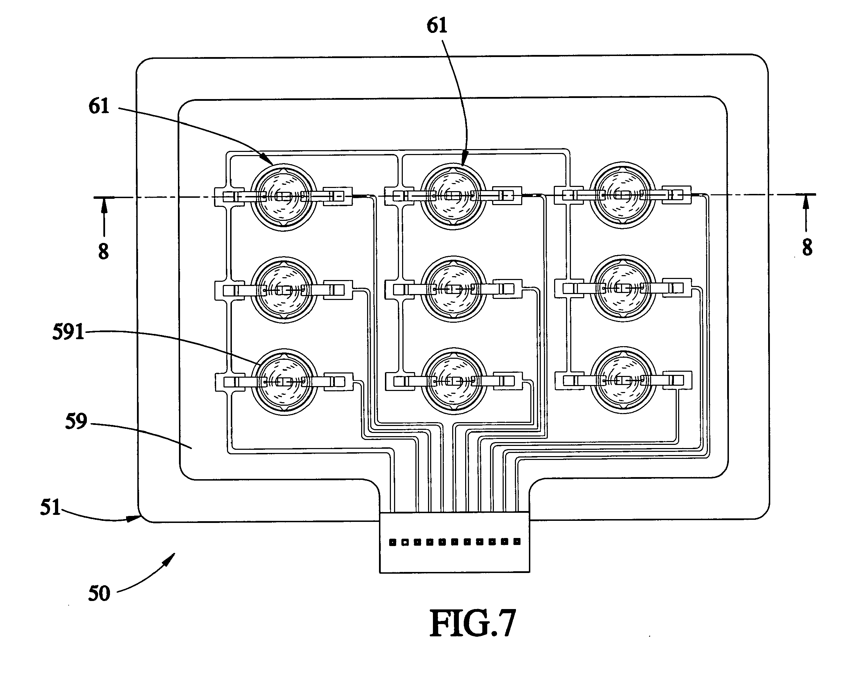

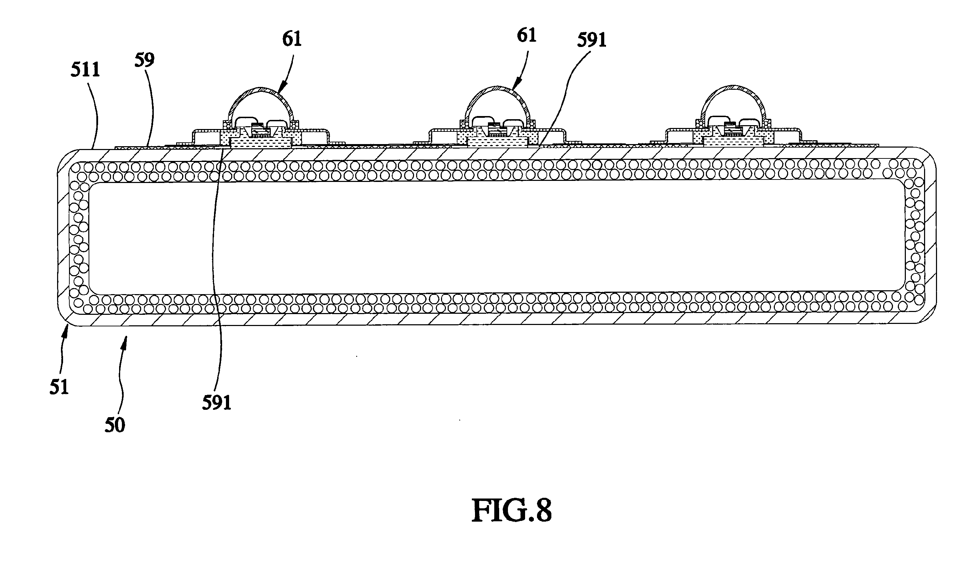

As shown in FIG 6 to FIG 8, a combination assembly of LED and liquid-vapor thermally dissipating device 50 of the third preferred embodiment of the present invention, which is similar to the assembly 10 of the first embodiment, except that:
A liquid-vapor thermally dissipating device 51 has a flat surface 511.

A circuit board 59 is on the flat surface 511, which has a plurality of bores 591 arranged in matrix. A plurality of LED units 61 are received in the bores 591 respectively.

The main difference is that the third embodiment provides the LED units 61 in matrix, and the rest structure, operation mode and functions are as same as the first embodiment, and we will not describe it again.

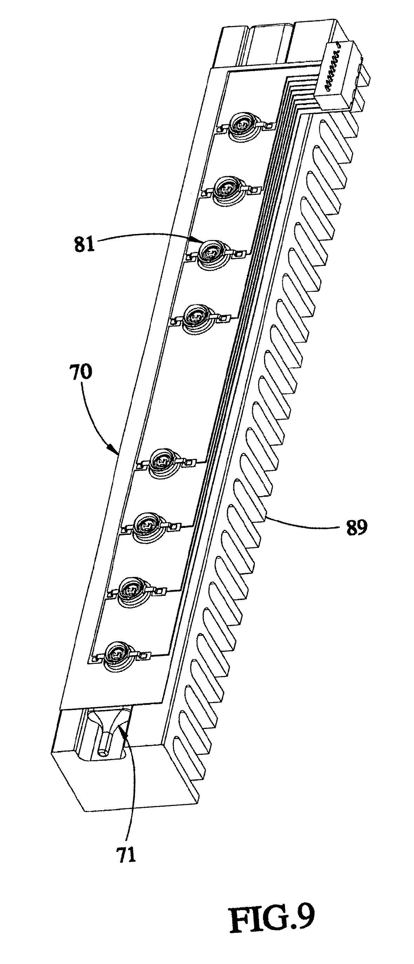

As shown in FIG 9, a combination assembly of LED and liquid-vapor thermally dissipating device 70 of the fourth preferred embodiment of the present invention, which is similar to the assembly 10 of the first embodiment, except that:
A liquid-vapor thermally dissipating device 71 is connected to a heat sink 89.

As a result, the heat generated by lighting LED units 81 is transmitted to the heat sink 711 through the liquid-vapor thermally dissipating device 71 for heat transmission by a greater size of the heat sink 711.

The operation mode and functions of the second embodiment are as same as the first embodiment, and we will not describe it again.

In conclusion, the advantages of the present invention are:
Higher performance of heat transmission: to compare with the prior art, the present invention has no intermediate between the LED chips and the liquid-vapor thermally dissipating device, so that the present invention has less heat transmission resistance. The present invention provides the LED chips mounted on the liquid-vapor thermally dissipating device directly so that the heat of the LED chips may be transmitted to the liquid-vapor thermally dissipating device directly for heat transmission that has a greater performance of heat transmission than the prior art.

The description above is a few preferred embodiments of the present invention and the equivalence of the present invention is still in the scope of the claim of the present invention.

## Claims

1. A combination assembly of LED and liquid-vapor thermally dissipating device (10), comprising:
a liquid-vapor thermally dissipating device (11) including a metal shell (12) with liquid and capillarity structures (16) therein;
a circuit board (19) provided on the liquid-vapor thermally dissipating device (11); and
at least one LED unit (21) including a heat transmission base (22) provided on the metal shell (12) of the liquid-vapor thermally dissipating device (11), a LED chip (23) provided on the heat transmission base (22), a package device (24) encapsulating the LED chip (23) and two transmitting plates (25) having ends electrically connected to the LED chip (23) and ends exposed out of the package device (24) and electrically connected to the circuit board (19).

2. The combination assembly of LED and liquid-vapor thermally dissipating device (10) as defined in claim 1, wherein the LED unit (21) further includes an insulating frame (26), to which the transmitting plates (25) are connected, surrounding the heat transmission base (22) and two wires (27) connecting the LED chip (23) and the transmitting plates (25).

3. The combination assembly of LED and liquid-vapor thermally dissipating device (10) as defined in claim 2, wherein the LED chip (23) has two electrode plates (231) on a top thereof and an insulating layer (232) on a bottom thereof to be mounted on the heat transmission base (22), and the wires (27) have ends connected to one of the electrode plates (231) and one of the transmitting plates (25) respectively, and the package device (24) partially encapsulates the insulating frame (26) and the transmitting plates (25).

4. The combination assembly of LED and liquid-vapor thermally dissipating device (10) as defined in claim 2, wherein the package device (24) has a lid (241) provided to the insulating frame (26), and the LED chip (23) and the wires (27) are between the package device (24) and the insulating frame (26).

5. The combination assembly of LED and liquid-vapor thermally dissipating device (10) as defined in claim 2, wherein the package device (24) is an encapsulant (24') encapsulating a top of the insulating frame (26), the wires (27) and the LED chip (23).

6. The combination assembly of LED and liquid-vapor thermally dissipating device (10) as defined in claim 1, wherein the liquid-vapor thermally dissipating device (11) is a heat pipe.

7. The combination assembly of LED and liquid-vapor thermally dissipating device (50) as defined in claim 6, wherein the circuit board (59) has a plurality of bores (591) arranged in series, and there are a plurality of LED units (61) received in the bores (591) respectively.

8. The combination assembly of LED and liquid-vapor thermally dissipating device (30) as defined in claim 6, wherein the liquid-vapor thermally dissipating device (31) has an end face (311), on which the circuit board (39) and the LED unit (41) are provided.

9. The combination assembly of LED and liquid-vapor thermally dissipating device (50) as defined in claim 1, wherein the liquid-vapor thermally dissipating device (51) has a flat surface (511).

10. The combination assembly of LED and liquid-vapor thermally dissipating device (50) as defined in claim 9, wherein the circuit board (59), which has a plurality of bores (591) arranged in matrix, is on the flat surface (511) and there are a plurality of the LED units (61) received in the bores (591).

11. The combination assembly of LED and liquid-vapor thermally dissipating device (70) as defined in claim 1, wherein the liquid-vapor thermally dissipating device (71) is connected to a heat sink (89).
